# EUROPEAN PATENT APPLICATION

(11) **EP 4 145 157 A1**
(43) Date of publication of application: **08.03.2023**
(21) Application number: 21195133.0
(22) Date of filing: 06.09.2021
(51) Int. Cl.: G01R 31/392

(54) **BATTERY SYSTEM STATE OF HEALTH MONITORING SYSTEM**

(71) Applicant: Dukosi Limited, Edinburgh, EH14 4AP (GB)
(72) Inventor: Buhari, Mohammed Sulaiman, Edinburgh (GB); Darroch, Jim, Edinburgh (GB)
(74) Representative: Finnegan Europe LLP

(57) **Abstract**

A monitoring system (120) for a battery system (110) comprising one or more battery cells (110). Monitoring system (120) comprises one or more sensors (125) for measuring characteristics associated with battery system (110) during a charge or discharge operation, and a processing device (130) communicatively coupled with the one or more sensors (125). Processing device (130) comprises a preprocessor (135) configured to receive measurement data from the at least one sensor (125) and a neural network (140) configured to receive processed data from preprocessor (135). Based on the received measurement data, preprocessor (135) determines a rate of change of a first measured characteristic against one of: time; or a second measured characteristic associated with battery system (110) measured during the charge or discharge operation, wherein the second measured characteristic is different from the first measured characteristic. Neural network (140) is configured to use the determined rate of change from preprocessor (135) as an input to determine a state of health (SOH) of battery system (110).

## Description

### Technical Field

The present disclosure relates to the field of battery technology, energy cells and battery monitoring systems and solutions for determining the State of Health (SoH) of a battery system. In particular, embodiments of the disclosure relate to a monitoring system, a processing device, a method and a computer-readable medium for determining state of health of a battery system.

### Background

Battery systems are used in a wide range of modern electric power applications. For example, they are used to power electric vehicles, they are used in industrial power applications, in transportation, energy storage, and in commercial applications such as powering of modern electronic devices. Given the relatively high-power demands of such applications, a battery system often comprises multiple battery cells coupled together to achieve the required power output. The battery cells may be coupled together to form a battery pack, and the battery system may comprise one or more battery packs.

It is common to monitor the voltage and current of battery cells in a battery pack to determine the operational state of the battery cells. Typically, a battery system will be connected to a battery management system which receives signals indicating the current operational states of the battery cells to ensure that the battery system operates within its safe operating limits (i.e. the combination of voltage, current and temperature conditions under which the battery system is expected to operate without self-damage). For further details, the interested reader is directed to the following Wikipedia website: https://en.wikipedia.org/wiki/Battery management system.

One aspect of a battery system which would be highly desirable to monitor is the State of Health or SoH of the battery system. The SoH of a battery system can be defined as a measure of the percentage of the charge capacity of an aged battery system relative to the battery system's charge capacity at the time of manufacture. Typically, this will be 100% at the time of manufacture and will decrease over time and use. Monitoring a battery system's SoH provides visibility of the battery system's degradation since manufacture and can be used to implement effective operation and maintenance of the battery system. However, unlike temperature, voltage or current, SoH cannot be measured directly. Rather it must be determined based on battery system behavior during charging and discharging operations.

A conventional method for determining SoH of a battery system will normally involve performing a full slow (low C-rate) charge/discharge cycle on a battery system to measure the battery system's charge capacity and then determining the ratio of that measured charge capacity to the charge capacity of the battery system when first manufactured. However, such an approach is not always possible or feasible not least as some battery systems are never fully charged/discharged as doing some may adversely impact the lifetime of a battery system or interfere with normal operation of the battery powered application.

As direct measurement of SoH is often impractical other methods have been proposed.

One proposed approach is to design a model exhibiting behaviour corresponding with that of the battery system. Such a model is typically implemented using software, but some very simple models can be calculated using fixed purpose hardware. A model may be an equivalent circuit model, where charge retention capacity is a state variable that is varied to reduce the error in predicted open circuit voltage, for instance by a Kalman Loop.

However, with model-based methods, it is hard to decouple the calculated charge retention capacity from other state variables, such as the ratio of the remaining charge capacity of the battery system to a full charge capacity of the battery, often referred as the State of Charge or SoC of the battery system, and internal resistance. Further, where a model is a physical model in which charge capacity is determined by the physical characteristics of the cell and allowed to change, accurate modelling demands knowledge of many different cell parameters and other contributary factors such as loss of available lithium from a cell with use, most of which cannot be directly measured and therefore the practicality of model based methods is limited.

A different approach is disclosed in CN110824364A which proposes using a deep neural network to perform the SoH prediction. Deep neural networks comprise multiple hidden layers between the input and output layers and are capable of modelling complex non-linear relationships with fewer data units than a similarly performing shallow neural network comprising fewer (typically less than ten) hidden layers between the input and output layers.

However, deep neural networks such as that described in CN110824364A require intensive processing power which render such approaches unsuitable for real-world implementation as the processing requirements necessary for implementing a deep neural network exceed processing capacity of chips in embedded systems which might be used to provide in situ monitoring of battery systems such as battery systems in electric vehicles.

While advancements in cloud processing capabilities mean that some of the processing effort for implementing deep neural networks can be performed in the cloud, remote implementation of a deep neural network raises other issues. Particularly in case of SoH prediction, remote processing of data by a deep neural network requires a battery monitoring system to have constant connectivity with the remote processing system and requires the system support transmission of large amounts of real-time data. These demands mean that in practical terms SoH prediction based on a deep neural network is limited to laboratory environments which can avoid these problems.

In view of the above, an alternative approach to the monitoring of SoH of a battery system is required.

It is an object of at least some embodiments of the present disclosure to address one or more shortcomings of the prior art systems.

### Summary of the Invention

One aspect of the present disclosure provides a monitoring system for a battery system comprising one or more battery cells. The monitoring system comprises one or more sensors for measuring characteristics associated with the battery system during a charge or discharge operation, and a processing device communicatively coupled with the one or more sensors. The processing device comprises a preprocessor configured to receive measurement data from the at least one sensor and a neural network configured to receive processed data from the preprocessor. Based on the received measurement data, the preprocessor determines a rate of change of a first measured characteristic against one of: time; or a second measured characteristic associated with the battery system measured during the charge or discharge operation, wherein the second measured characteristic is different from the first measured characteristic. The neural network is configured to use the determined rate of change from the preprocessor as an input to determine a state of health (SOH) of the battery system.

Another aspect of the present disclosure provides a processing device for use in a battery monitoring system. The processing device comprises a preprocessor configured to receive measurement data from at least one sensor and a neural network configured to receive processed data from the preprocessor. Based on the received measurement data, the preprocessor determines a rate of change of a first measured characteristic against one of: time; or a second measured characteristic associated with the battery system measured during the charge or discharge operation, the second measured characteristic being different from the first measured characteristic. The neural network is configured to use the determined rate of change from the preprocessor as an input to determine a state of health (SOH) of the battery system.

Another aspect of the present disclosure provides a method for determining a state of health (SOH) of a battery system. In accordance with the method, measurement data indicative of one or more characteristics associated with the battery system during a charge or a discharge operation is received. Based on the received measurement data, a rate of change of a first measured characteristic against one of: time; or a second measured characteristic associated with the battery system measured during the charge or discharge operation is determined, wherein the second measured characteristic is different from the first measured characteristic. The determined rate of change is then used as an input to a neural network, to determine a state of health (SOH) of the battery system.

A further aspect of the disclosure provides a non-transitory computer readable medium for configuring a processing device or a monitoring system.

Other features of the disclosure will be apparent from the dependent claims, and the description which follows. Further features of the present disclosure will become apparent from the following description of exemplary embodiments with reference to the attached drawings.

### Brief Description of Drawings

Further aspects and embodiments will become apparent from the following description and accompanying drawings in which:
Figure 1 is a schematic illustration of a battery system and a monitoring system for determining a state of health of the battery system in accordance with an embodiment of the disclosure;
Figure 2 is a process flow chart illustrating a method for determining a state of health of a battery system using the monitoring system of Figure 1;
Figures 3a and 3b are exemplary graphs of the manner in which the rate of change of voltage with charge (dV/dQ) measured over a charge/discharge cycle varies with the state of health of an exemplary battery system.
Figures 4a and 4b are exemplary graphs of the manner in which the rate of change of voltage with State of Charge (dV/dSoC) measured over a charge/discharge cycle varies with the state of health of an exemplary battery system.
Figure 5 is an exemplary graph of the manner in which the rate of change of voltage with State of Charge (dV/dSoC) measured over a charge/discharge cycle and the state of health of the battery system charged at multiple different charging rates varies.
Figure 6 is a process flow chart illustrating a method for training a neural network to determine state of health of a battery system based on a measured characteristic differential in accordance with an embodiment of the disclosure.

### Detailed Description of Embodiments

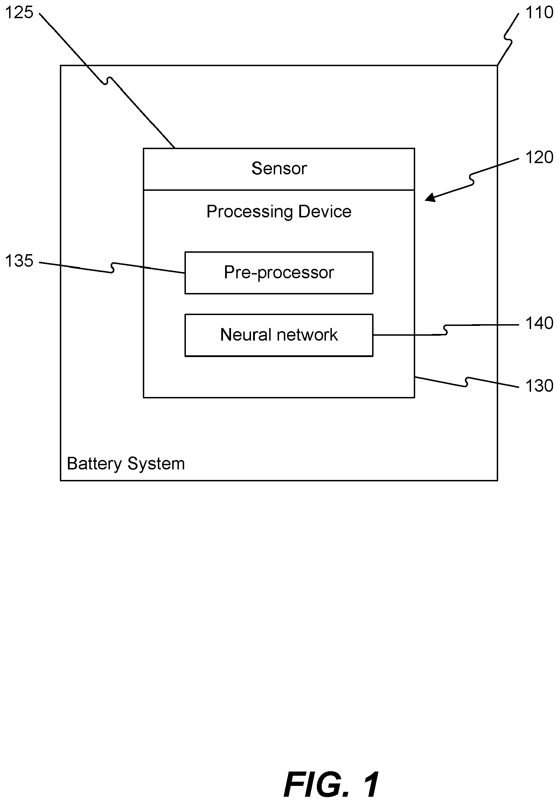

Figure 1 is a schematic illustration of battery system 110 and monitoring system 120 for determining SoH of battery system 110 in accordance with an embodiment of the disclosure.

Battery system 110 may comprise a single battery cell. Alternatively, in other embodiments, battery system 110 may be a battery pack comprising a plurality of battery cells. In embodiments where battery system 110 comprises a single battery cell, monitoring system 120 will be configured to determine SoH of that battery cell. In other embodiments where battery system 110 comprises a plurality of battery cells, monitoring system 120 may be configured to determine the collective SoH of the plurality of battery cells.

Monitoring system 120 comprises one or more sensors 125 for measuring characteristics of battery system 110 during charging and/or discharging operations. Sensors 125 may comprise one or more sensors configured to measure voltage and/or current of battery system 110 during charging and/or discharging operations. In some embodiments, sensor 125 may also comprise one or more sensors configured to measure temperature of battery system 110.

Monitoring system 120 further comprises processing device 130 configured to receive signals and/or data from the sensors 125 representative of the measured characteristics of battery system 110 (e.g. signals and/or data indicative of voltage, current temperature etc.). In some embodiments, processing device 130 may be configured to timestamp received sensor data to facilitate time series analysis of battery system characteristics.

In some embodiments, processing device 130 may be coupled to sensor 125. In other embodiments, a communicative coupling exists between processing device 130 and sensor 125, enabling battery system sensor data to be relayed to the processing device 130.

The applicants have appreciated that the complexity of a neural network required to derive a measurement of SoH from measured characteristics of a battery system can be greatly reduced by pre-processing the measured characteristics so that differential (i.e., rate of change data) is processed by a neural network instead of processing the raw measurements of charge, voltage, and temperature etc. The extent of such simplification is that rather than deriving a SoH measurement using a deep neural network as has been proposed in the past, it is possible to derive a SoH measurement using a shallow neural network. This reduces the computational burden on processing device 130 to determine the SoH of battery system 110 and makes it feasible for a SoH measurement to be determined with limited processing capabilities, such as may be available in embedded systems.

Further the applicants have appreciated that a measurement of SoH can be made based on such determined differential data for a limited portion of the charge/discharge cycle without a significant loss of accuracy. Therefore, by pre-processing data representative of measured characteristics to determine derivative data of rates of change of such characteristics, it is possible to determine measurements of SoH for a wide range of battery systems, including battery systems where battery cells or battery packs are never fully charged or discharged.

To that end, in this embodiment, processing device 130 comprises a pre-processor 135 configured to determine rate of change data of measured characteristics received from sensor 125 and neural network 140 trained to determine SoH from measured battery system characteristics which have been processed by pre-processor 135.

Pre-processor 135 may take the form of, but is not limited to, a microprocessor, embedded processor, or the like, or may be integrated in a system on a chip (SoC). In some embodiments, pre-processor 135 may comprise a fixed-function digital logic circuit. Furthermore, according to some embodiments, pre-processor 135 may be from the family of processors manufactured by Intel^{®}, AMD^{®}, Qualcomm^{®}, Apple^{®}, NVlDIA^{®}, or the like. Pre-processor 135 may also be based on the ARM architecture, a mobile processor, or a graphics processing unit, etc. The disclosed embodiments are not limited to any specific type of pre-processor.

In an embodiment, neural network 140 is a feedforward neural network comprising a plurality of processing layers for determining SoH of the monitored battery system 110 trained in the manner described below to determine SoH from a particular battery system characteristic differential.

Preferably, neural network 140 is a shallow feedforward neural network comprising a limited number of nodes and layers. In an embodiment, neural network 140 may comprise an input layer, a hidden layer and an output layer. In some embodiments, neural network 140 may comprise a plurality of hidden layers. In one embodiment, neural network 140 may comprise between 4 and 6 hidden layers.

In some embodiments, processing device 130 may be configured to successively trigger each layer of a plurality of layers of neural network 140 to determine the SoH of battery system 110. Triggering layers of neural network 140 in this way further reduces the processing resources required to determine SoH by a factor equal to the number of layers in neural network 140. This combined with the provision of pre-processor 135 which derives rate of change data from measurements made by sensor 125 further facilitates the determination of SoH by monitoring system 120 which may have limited processing capacity. Further this can be achieved without jeopardizing the accuracy of the SoH determination. Such successive triggering of layers of neural network 140 may be initiated via software on processing device 130. Advantageously, battery system SOH determinations using the disclosed techniques can be performed in a single iteration of neural network 140 using data collected for a given charge/discharge cycle.

In some embodiments, processing device 130 may additionally comprise post-processing means configured to remove noise or unexpected values from the output of the neural network. In an embodiment, post-processing means may comprise at least one of a lowpass filter or a smoothing filter.

Processing device 130 may report the determined battery system SoH, and optionally any additional measured characteristics of the battery system to a Battery Management System (BSM) not illustrated. The BMS may compare performance of multiple battery systems (or battery cells). Where performance of a battery system is found to differ from other battery systems by more than a predetermined amount, this may be indicative of a fault in the battery system and prompt the BMS to raise a fault flag against the identified battery system. The predetermined amount may be initially set to default bounds set at manufacture. The predetermined amount may be selected in response to behaviour learned from previous battery systems. In some embodiments, the BMS may send collected data to the cloud on a continuous/regular/irregular schedule. Identified divergence in battery system performance may be used to optimize operation and/or maintenance of the battery system.

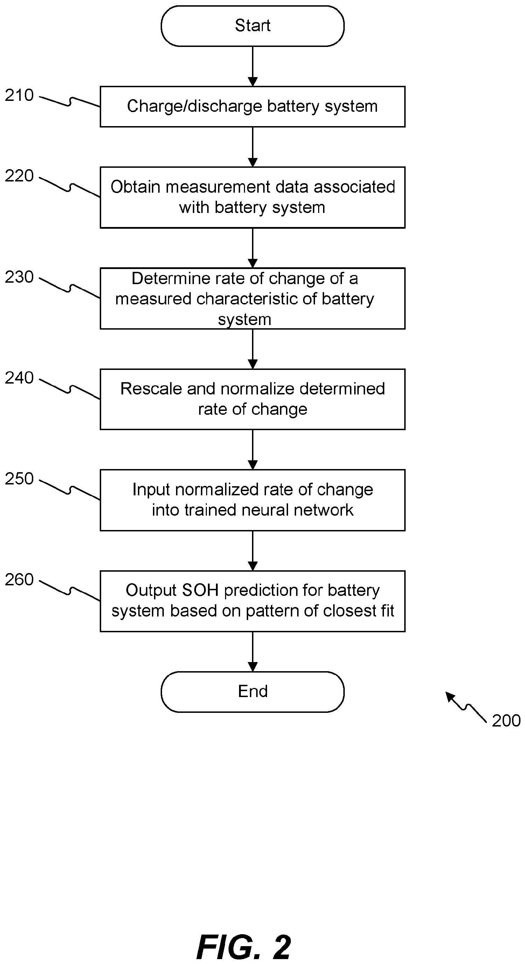

Figure 2 is a process flow chart illustrating method 200 for determining a state of health of battery system 110 using monitoring system 120 illustrated in Figure 1.

As an initial step 210, battery system 110 undergoes at least a partial charge/discharge cycle while sensor 125 collects, at step 220, measurement data indicative of characteristics associated with battery system 110 as battery system 110 is charged/discharged. In an embodiment, collected measurement data may include current and voltage data. In some embodiments, the temperature of battery system 110 may also be measured.

In embodiments, measurement data may be collected by sensor 125 over a sub-range of a full charge/discharge cycle on battery system 110. For example, measurement data may be collected from 20% to 80% of the maximum charge capacity of the battery system (SoC). In other embodiments, measurement data may be collected during a charge/discharge range of one of 30-70%SoC (or 70-30%SoC), 40-60%SoC (or 60-40%SoC). In an embodiment, the range of the charge/discharge operation over which measurement data is collected may be one of a 10%, 20%, 30%, 40%, 50%, 60%, 70%, 80%, or 100% change in SoC. While the described methods may provide sufficient SoH determinations using a smaller range of charge/discharge data, the accuracy and effectiveness of these methods on battery system variants (e.g., battery systems having different designs or cell chemistries) may be improved by extending the range of the charge/discharge operation over which measurement data is collected. In some embodiments, the charge/discharge range may be that which occurs naturally in the battery system application. In other embodiments, the sub-range may be determined based on properties of a battery system to avoid over-charging or over-discharging the battery system so as to prolong its longevity. Embodiments of the disclosure are not limited to a single charge/discharge range. In some embodiments, monitoring system 120 may measure different charge/discharge ranges for different charge/discharge cycles.

At step 220, pre-processor 135 receives measurement data indicative of a characteristic associated with battery system 110 from sensor 125. Pre-processor then determines, at step 230, based on the received measurement data, a rate of change of the characteristic against either time, or another characteristic of battery system 110 during the charging/discharging operation.

In an embodiment, pre-processor 135 may be configured to determine a rate of change of voltage against charge (dV/dQ) for battery system 110 based on the measurement data received from sensor 125. In the above embodiment, the received measurement data may include current and voltage measurement data associated with battery system 110 over the duration of the charge/discharge operation.

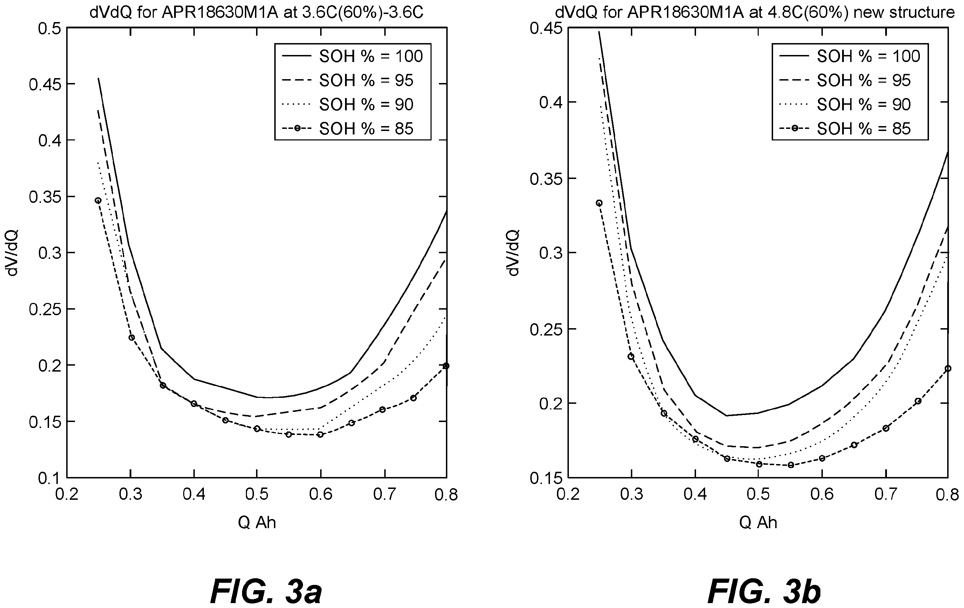

Figures 3a and 3b are exemplary graphs of the manner in which the rate of change of voltage with charge (dV/dQ) measured over a charge/discharge cycle varies with the state of health of an exemplary battery system. The rate at which a battery system is charged or discharged is known as the C-rate. The C-rate of a charge/discharge operation may be determined based on the charge/discharge current through a battery system divided by the theoretical current draw under which the battery system would deliver its nominal rated capacity in one hour. Figure 3a illustrates dV/dQ measured for battery system 110 during a charging operation with a C-rate of 3.6, whereas Figure 3b illustrates the same, but for a charging operation with a C-rate of 4.8. As seen in the illustrated figures, a clear trend is distinguishable as battery system 110 degrades from 100% to 85% SoH. The illustrated graphs may be used to identify where a battery system of unknown SoH fits within the graph in order to predict the SoH value of the battery system, e.g., via interpolation/extrapolation. The x-axis of the figures represents charge derived through coulomb counting over a range starting from the open circuit voltage at Vmin using current measurement data from battery system 110. Calculated SoH results obtained using dV/dQ analysis in the disclosed methods have proven to be highly accurate, achieving less than 1% RMSE using an absolute dV/dQ relationship determined from measurement data collected over a charging range of 0.35 Ah to 0.70 Ah. Therefore, unlike the prior art techniques, the disclosed solutions can accurately determine SoH using measurement data from a partial charge/discharge cycle at higher C-rates.

In another embodiment, pre-processor 135 is configured to determine a rate of change of voltage against SoC (dV/dSoC) for battery system 110 based on the measurement data received from sensor 125. In the above embodiment, the received measurement data may include current and voltage data associated with battery system 110 over the duration of the charge/discharge operation. Pre-processor 135 may be configured to determine SoC from the received measurement data using any of the suitable methods known in the art.

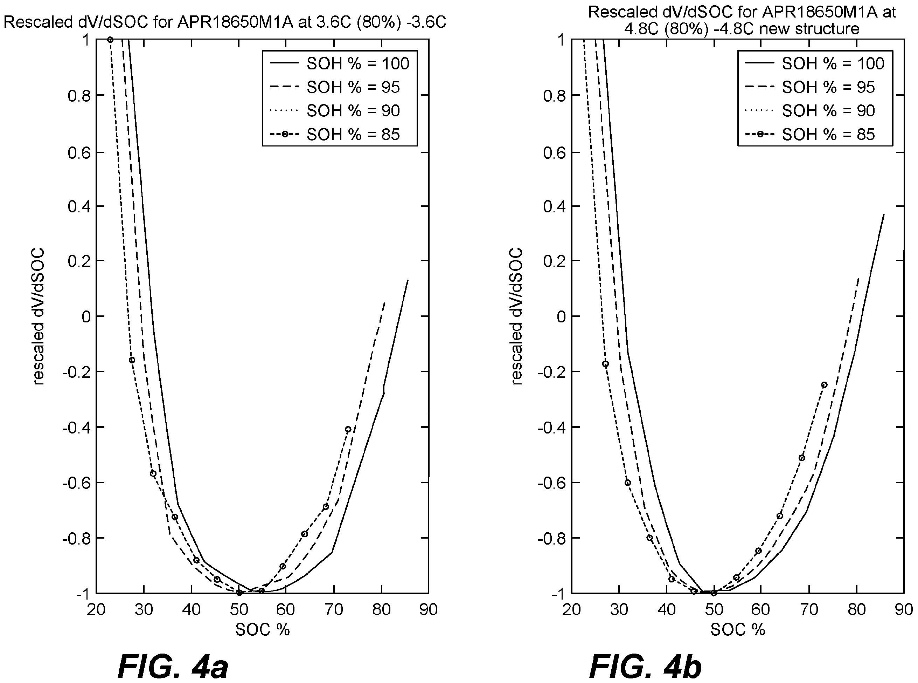

Figures 4a and 4b are exemplary graphs of the manner in which the rate of change of voltage with State of Charge (dV/dSoC) measured over a charge/discharge cycle varies with the state of health of an exemplary battery system. Figure 4a illustrates dV/dSoC measured for battery system 110 during a charging operation with a C-rate of 3.6, whereas Figure 4b illustrates the same, but for a charging operation with a C-rate of 4.8. The x-axis of the figures represents SOC of battery system 110 calculated as percent of available Q Ah vs maximum Q Ah achieved at the end of each charge cycle. As with the dV/dQ method described above, the illustrated figures show a distinguishable trend as battery system 110 degrades from 100% to 85% SoH. SoH simulations using dV/dSoC in the described method have achieved a less than 1% RMSE using measurement data collected over a charging range of 25-80%SoC.

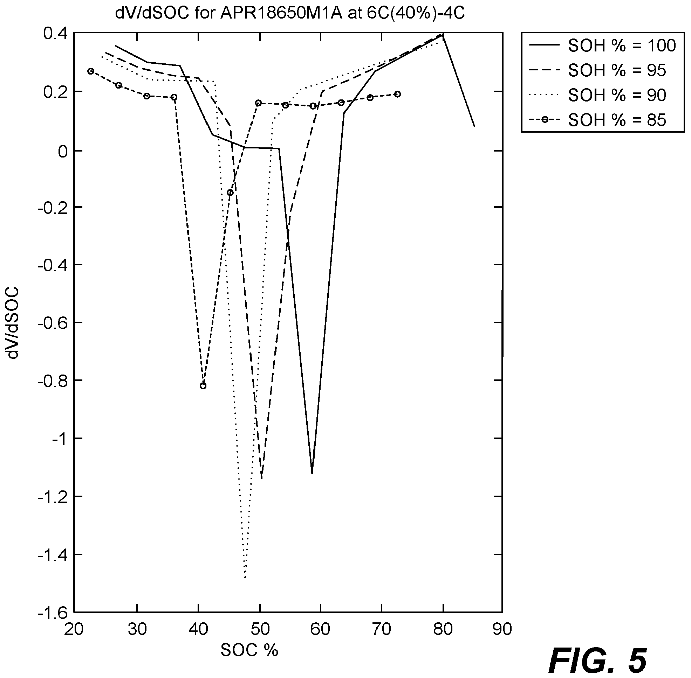

In many applications it is desired to vary the C-rate of a charge/discharge operation based on the SoC of the battery system. For example, in some cases, battery system 110 may be charged at a high C-rate when its SoC is below 50% followed by a lower C-rate charge once its SoC is above 80%. When charge rate is transitioned from high C-rate to lower C-rate a discontinuity or step response in voltage can be seen across battery system 110 due to internal resistance and charge characteristics of battery system chemistry. This results in a discontinuity in dV/dSOC measurements as shown in figure 5. Unlike the prior art SoH techniques, the combination of battery system characteristic differential analysis and trained neural network pattern recognition used by the disclosed methods has proven to be effective in determining battery system SoH from measurement data collected over a charge/discharge cycle comprising multiple different charging rates.

Figure 5 is an exemplary graph of the manner in which the rate of change of voltage with State of Charge (dV/dSoC) measured over a charge/discharge cycle and the state of health of the battery system charged at multiple different charging rates varies. The graph shows the determined dV/dSoC for battery system 110 charged to 40% SoC at a C-rate of 6 followed by a charge to 80% at a C-rate of 4. The use of additional processing steps to mask absolute dV/dSOC values below a fixed threshold (which may be based on battery system configuration) enables SoH determination using measurement data comprising multiple charge rates during single charge cycle. Thus, additional processing on the resulting battery system characteristic differential data ensures that the SoH determination is not skewed by the interference caused from swapping between charging rates.

In another embodiment, pre-processor 135 is configured to determine a rate of change comprising at least one of dV/dt, dV/dT, dQ/dT, dQ/dSoC, dQ/dt, dSoC/dT. For embodiments in which a rate of change of a battery system characteristic against time is determined, pre-processor 135 may first timestamp received measurement data in order to analyze the battery system characteristics with respect to time for the charge/discharge operation. Each battery system characteristic differential has its own advantages and disadvantages associated with it. For instance, while dV/dt has been found to provide great SoH accuracy for a single battery system design, dV/dt does not perform as well as other differentials (such as dV/dQ and dV/dSoC) when used on battery system variants (e.g., dV/dt trained on cell chemistry A may be less capable in providing accurate SoH prediction for Cell chemistry B for which it has not been trained). Advantageously, the use of dV/dt also makes for simpler implementation since raw timestamped voltage measurements can be directly sampled without further data manipulation. The specific battery system characteristic differential used in the disclosed methods may therefore be selected based on the specific application.

In some embodiments, additional processing may be performed to rescale and/or normalize, at step 240, the determined rate of change. The rescaling and/or normalizing may be performed on the rate of change using any of the suitable methods known in the art. Rescaling and/or normalizing the determined rate of change improves the effectiveness of SoH determinations from measurement data associated with battery system variants. The Applicants have found that effective determination of SoH for battery system variants using normalized characteristic differentials is possible due to the fact that all battery systems exhibit a parabolic differential characteristic comparable to that of a trained dataset, as seen in figures 3a-4b. The precise relationship between SoH and the characteristic differential is expected to vary for different battery systems variants, however an initial estimation can be determined using battery systems specification information such as cyclic degradation data. As shown in Figures 4a and 4b, the range for the determined dV/dSoC is rescaled to the range 1 to -1 to facilitate easier weighting and to support higher resolutions, e.g., using 32 bits to represent 1 to -1 instead of the raw values. Additionally, lower measurement data accuracy from sensor 125 may be compensated for by reducing the sampling interval of the measurement data used to determine dV/dSOC. In an embodiment, a sampling interval of 0.5%-5% SOC may be used.

At step 250, the processed rate of change is used as an input into neural network 140, which uses pattern matching analysis on the received rate of change to determine and output, at step 260, a SoH for battery system 110.

In some embodiments, in addition to the determined rate of change, a true mean current measured through the battery system over the duration of the change/discharge operation may also be used as an input to neural network 140. The inclusion of mean current can improve SoH accuracy and battery system variant applicability, since differentials containing dV, dt, dT and dQ in isolation do not provide an indication of rate of charge for a given step. While rolling current averages may be used in some embodiments, this can introduce errors where charge/discharge rates vary during the charge/discharge cycle.

In some embodiments, in addition to the determined rate of change, the temperature of the battery system over the duration of the change/discharge operation may also be used as an input to neural network 140. In an embodiment, the true mean temperature of the battery system over the duration of the change/discharge operation may also be used as an input to neural network 140. The inclusion of temperature can improve SoH accuracy by correcting for changes in battery system behaviour resulting from temperature differences. In particular, variations in temperature affect both the internal resistance of a battery system and the extent to which charge is accessible from a battery system.

In some embodiments, post-processing may be performed on the output of neural network 140 in order to remove outliers and unexpected noise spikes. In some embodiments, values outside expected parameters are removed. In one embodiment, where a trough of a SoH curve is outside of the 40-60%SoC value expected, a post-processing phase may be implemented to remove this data from the curve, as shown in figure 4b. Post-processing the SoH output in this manner can compensate for a loss in accuracy resulting from the use of measurement data collected over a partial charge/discharge range. It will be appreciated that post processing steps may also implement standard deviation analysis, threshold levels and comparisons with historical/training data in the identification and removal of outlier/noise from the determined data set.

The determined SoH of battery system 110 can subsequently be used to modify effective operation of battery system 110 (e.g., to modify changing/discharging operations to preserve the life of battery system 110) and determine when replacement of battery system 110 (or one or more of its components) is required.

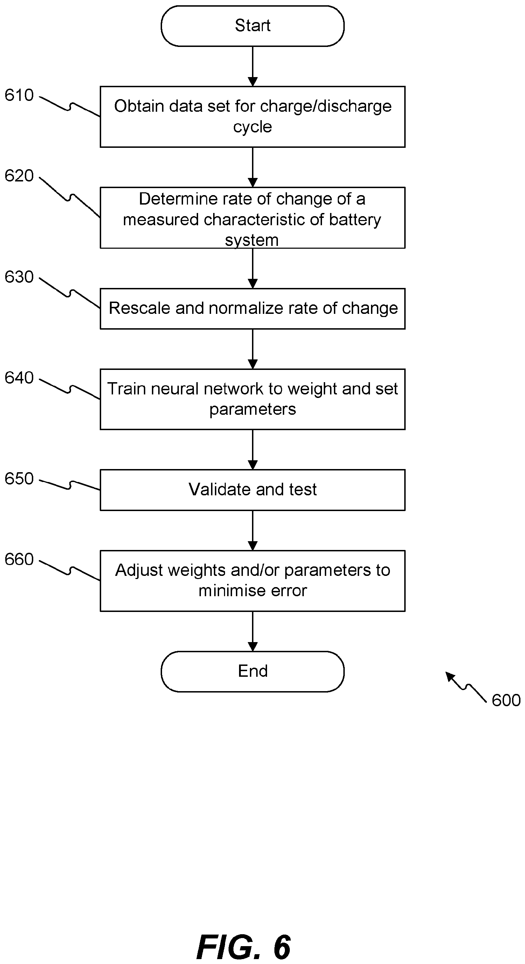

Figure 6 is a process flow chart illustrating method 600 for training a neural network to determine state of health of a battery system based on a measured characteristic differential in accordance with an embodiment of the disclosure. At step 610, training data is obtained comprising measurement data indicative of a battery system characteristic associated with a battery system during charge/discharge operations. The training data may include charging rates expected in the field application.

In an embodiment, neural network 140 may be trained using battery system characteristics sampled from an MIT data set. The training data set may be sourced from the public domain - MIT - https://data.matr.io/1/.

The obtained training data is used to determine, at step 620, a rate of change of a battery system characteristic against either time, or another characteristic of the battery system observed over the charge/discharge operation. The determined rate of change may then be rescaled and/or normalized, at step 630, using known techniques to standardize the training process and improve the effectiveness of neural network 140 on battery system variants. In particular, rescaling trains neural network 140 to focus on patterns of the determined rate of change and reduces the use of large values in implementation, enabling higher resolution fixed point conversion. In some embodiments, a filtering step may be implemented to remove unexpected/outlier values, as described above.

At step 640, the determined rate of change is used to train neural network 140 to weight and set parameters for processing the rate of change to determine the SoH for a battery system. In some embodiments, the training parameters may be set with a back-propagation method of Bayesian regularization.

Neural network 140 may have a configuration sized based on the application requirements. In one embodiment, the base network configuration may be [18 15 10 10 5 3]. In one embodiment, neural network 140 utilizes a Tanh function to determine SoH of a battery system. Activation/Transfer function: Tanh - enables rapid convergence with limited node count, however other known activation functions may be used. Vanishing gradient properties reduces the risk of exponential errors on an untrained dataset. Alternative activation functions used in regression problems such as Rectified Linear Unit (ReLU) functions require complex neural network with an order of magnitude greater node count to match prediction accuracy obtained from Tanh. Similar issues are expected in leaky ReLU and Swish activation functions. The limited range of the tanh (from -1 to 1) enables high precision conversion in fixed point operation.

The result of the trained neural network may then be validated and tested, at step 650, against battery system data using techniques known in the art. In some embodiments, validation of the neural network 140 may be performed on a portion (e.g., 15%) of the entire MIT dataset. In some embodiments, testing of neural network 140 may be performed on a portion (e.g., 15%) of the entire MIT dataset. Following the testing and validation step, neural network 140 may be optimized, at step 660, by adjusting the weightings and/or parameters to minimize the error in battery system SoH determinations.

An implemented algorithm trained on dV/dQ values has been proven to predict SoH of a Lithium iron phosphate (LFP) cell (A123 APR18650M1A 1.1Ah) with less than 1% RMSE error using absolute dV/dQ calculations taken from Q Ah range between 0.35Ah to 0.70Ah. A retrained algorithm with the identical MIT dataset using rescaled dV/dSoC v SoC data enabled accurate SoH prediction on other LFP cells (LithiumWerks APR18650M1B 1.2Ah) with prediction errors less than 3% RMSE. Rescaled dV/dQ or dV/dSoC were more accurate across all types of battery systems and thus provide a more generic solution.

In an embodiment, the training of a neural network may be performed in the cloud. The trained neural network 140 may be transferred to an embedded device and function without dependence on the cloud. Training neural network 140 in this manner removes the requirement for a continuous connection to the cloud in order for SoH determinations to be made, however in certain embodiments cloud connection may be utilized to support the SoH determination.

While the above embodiments describe techniques for determining battery system SOH defined with respect to capacity, it will be appreciated that such techniques will apply equally to other definitions of SOH known in the art. In particular, in some embodiments, SOH may be defined as one of:
- State of health with respect to power can be defined as the percentage of present maximum power a cell can deliver for a given time against maximum power the cell can deliver when manufactured;
- State of health with respect to fast charge capability can be defined as the ratio of present maximum charging rate against maximum charging rate for new cells; and
- State of health with respect to internal resistance of the cell can be defined as the ratio of increased internal resistance due to aging against internal resistance when the cell was manufactured.

The descriptions of the various embodiments of the present disclosure have been presented for purposes of illustration and are not intended to be exhaustive or limiting to the scope of the disclosure. Many modifications and variations of the disclosed embodiments will be apparent to those of ordinary skill in the art from the herein disclosed embodiments, without departing from the scope of the disclosure. The terminology used herein to disclose the embodiments of the disclosure was chosen to best explain the principles of the embodiments, the practical application or technical improvement over technologies found in the marketplace, or to enable others of ordinary skill in the art to understand the embodiments disclosed herein.

It is appreciated that certain features of the disclosure, which are, for clarity, described in the context of separate embodiments, may also be provided in combination in a single embodiment. Conversely, various features of the disclosure, which are, for brevity, described in the context of a single embodiment, may also be provided separately or in any suitable sub-combination or as suitable in any other described embodiment of the disclosure. Certain features described in the context of various embodiments are not to be considered essential features of those embodiments, unless the embodiment is inoperative without those elements.

Although the disclosure has been described in conjunction with specific embodiments thereof, it is evident that many alternatives, modifications and variations will be apparent to those skilled in the art. Accordingly, it is intended to embrace all such alternatives, modifications and variations that fall within the spirit and broad scope of the appended claims.

## Claims

1. A monitoring system for determining a state of health, SOH, of a battery system comprising one or more battery cells, the system comprising:
at least one sensor for measuring at least one characteristic associated with the battery system during a charge or discharge operation; and
a processing device communicatively coupled with the at least one sensor, the processing device comprising:
a preprocessor configured to:
receive measurement data from the at least one sensor; and
determine, based on the received measurement data, a rate of change of a first measured characteristic against one of: time; or a second measured characteristic associated with the battery system measured during the charge or discharge operation, the second measured characteristic being different from the first measured characteristic; and
a neural network configured to determine, using the determined rate of change, a state of health, SOH, of the battery system.

2. The monitoring system of claim 1, wherein the at least one sensor comprises at least one of: a temperature sensor; a voltage sensor; a current sensor; or a combination of the voltage sensor, the current sensor, and/or the temperature sensor.

3. The monitoring system of any preceding claim, wherein the first measured characteristic comprises one of: voltage; charge; or state of charge.

4. The monitoring system of any preceding claim, wherein the second measured characteristic comprises one of: charge; state of charge; temperature.

5. The monitoring system of any preceding claim, wherein the first measured characteristic is voltage, and the second measured characteristic is state of charge.

6. The monitoring system of any one of claims 1 to 3, wherein the first measured characteristic is voltage, and the second measured characteristic is charge.

7. The monitoring system of any one of claims 5 or 6, wherein the preprocessor is further configured to normalize the determined rate of change.

8. The monitoring system of any preceding claim, wherein the neural network comprises a plurality of layers, wherein the processing device is configured to successively trigger each layer of the plurality of layers to determine the state of health of the battery system.

9. A battery system comprising the monitoring system of any preceding claim.

10. A processing device for use in the monitoring system of any one of claims 1 to 8, the processing device comprising:
a preprocessor configured to:
receive, via at least one sensor, measurement data indicative of at least one characteristic associated with the battery system during a charge or a discharge operation; and
determine, based on the received measurement data, a rate of change of a first measured characteristic against one of: time; or a second measured characteristic associated with the battery system measured during the charge or discharge operation, the second measured
characteristic being different from the first measured characteristic; and
a neural network configured to determine, using the determined rate of change, a state of health, SOH, of the battery system.

11. A computer implemented method for determining a state of health, SOH, of a battery system, the method comprising:
receiving, via at least one sensor, measurement data indicative of at least one characteristic associated with the battery system during a charge or a discharge operation;
determining, based on the received measurement data, a rate of change of a first measured characteristic against one of: time; or a second measured characteristic associated with the battery system measured during the charge or discharge operation, the second measured characteristic being different from the first measured characteristic; and
determining, using a neural network, a state of health, SOH, of the battery system using the determined rate of change as input data to the neural network.

12. The method of claim 11, further comprising normalizing the determined rate of change.

13. The method of claim 11 or claim 12, wherein the neural network comprises a plurality of layers, and the method further comprises successively trigger each layer of the plurality of layers to determine the state of health of the battery system.

14. The method of any of claims 11-13, wherein the first measured characteristic comprises one of: voltage; charge; or state of charge; and the second measured characteristic comprises one of: charge; state of charge; temperature, preferably wherein the first measured characteristic is voltage and the second measured characteristic is charge or state of charge.

15. A computer-readable medium comprising instructions which when executed by a processor, cause the processor to perform the method according to any one of claims 11 to 14.
